(19) 

Europäisches Patentamt
European Patent Office
Office européen des brevets

(11) **EP 1 420 261 B1**

(12) **EUROPÄISCHE PATENTSCHRIFT**

(45) Veröffentlichungstag und Bekanntmachung des Hinweises auf die Patenterteilung:
**12.12.2007 Patentblatt 2007/50**

(51) Int Cl.:
***G01R 31/36*** *(2006.01)*

(21) Anmeldenummer: **03021286.4**

(22) Anmeldetag: **19.09.2003**

(54) **Verfahren zur Ermittlung der Ladungsaufnahme einer Speicherbatterie**

Process for determination of the charge consumption of a storage battery

Procédé pour la détermination de la charge consommée d'une batterie de stockage

(84) Benannte Vertragsstaaten:
**AT BE BG CH CY CZ DE DK EE ES FI FR GB GR HU IE IT LI LU MC NL PT RO SE SI SK TR**

(30) Priorität: **14.11.2002 DE 10253051**

(43) Veröffentlichungstag der Anmeldung:
**19.05.2004 Patentblatt 2004/21**

(73) Patentinhaber: **VB Autobatterie GmbH & Co. KGaA 30419 Hannover (DE)**

(72) Erfinder:
- **Richter, Gerolf, Dr. Ing.**
  **31139 Hildesheim (DE)**
- **Koch, Ingo, Dipl.-Ing.**
  **31879 Hameln (DE)**

(74) Vertreter: **Gerstein, Hans Joachim et al Gramm, Lins & Partner GbR Theodor-Heuss-Strasse 1 38122 Braunschweig (DE)**

(56) Entgegenhaltungen:
**DE-A- 3 108 844         US-A- 5 936 383**

**Beschreibung**

Die Erfindung betrifft ein Verfahren zur Ermittlung der Ladungsaufnahme einer Speicherbatterie ausgehend von einem anfänglichen Ladenzustand zu Beginn der Ladungsaufnahme.

Die Erfindung betrifft weiterhin eine Überwachungseinrichtung für Speicherbatterien mit einer Batterietemperatur-Messeinheit und mit Rechenmitteln zur Ermittlung der Ladungsaufnahme der Speicherbatterie nach dem oben genannten Verfahren.

Die Erfindung betrifft weiterhin ein Computerprogramm mit Programmcodemitteln zur Durchführung des oben genannten Verfahrens.

Bei dem Betrieb von Speicherbatterien, insbesondere von Starterbatterien in Kraftfahrzeugen, besteht ein Bedarf, den momentanen Zustand der Speicherbatterie zu bestimmen und einen zukünftigen Zustand bei angenommenen Umgebungs- und Batteriezustandsbedingungen vorherzusagen. Dabei ist es erwünscht, auch die im Ladebetrieb aufgenommene Ladung zu ermitteln.

Hierzu ist bekannt, während der Betriebsdauer der Speicherbatterie kontinuierlich den Batteriestrom zu messen. Aus dem umgesetzten Strom kann die in die Speicherbatterie hineinfließende Ladung bzw. die der Speicherbatterie entnommene Ladung berechnet und durch Bilanzierung der Ladungszustand ermittelt werden.

Weiterhin ist bekannt, die Ladezustandsänderung einer Speicherbatterie mittels mathematischer Modelle, wie zum Beispiel mit Ersatzschaltbildern, zu ermitteln.

Bei diesem Verfahren muss nachteilig der Batteriestrom gemessen werden. Dies ist insbesondere bei Starterbatterien mit relativ hohen Anlasserströmen sehr aufwendig. Aus der US 5936383 A ist bekannt eine Ladungsaufnahme durch eine Exponentialfunktion mit einer der Batterietemperatur abhängigen Zeitkonstante zu bestimmen.

Aufgabe der Erfindung ist es daher, ein verbessertes Verfahren zur Ermittlung der Ladungsaufnahme einer Speicherbatterie zu schaffen, mit dem ohne Messung des Batteriestroms die im Ladebetrieb von der Speicherbatterie aufgenommene Ladung möglichst genau und mit geringen Messaufwand bestimmt werden kann.

Die Aufgabe wird mit dem gattungsgemäßen Verfahren erfindungsgemäß dadurch gelöst, dass die Ladungsaufnahme in Abhängigkeit von einer Exponentialfunktion mit einer Zeitkonstanten bestimmt wird. Dabei wird vorgeschlagen, dass die Zeikonstante mindestens in Abhängigkeit von dem Speicherbatterietyp und der Batterie- oder Elektrolyttemperatur festgelegt wird.

Durch Untersuchung hat sich nämlich gezeigt, dass die von einer Speicherbatterie aufgenommene Ladung sich exponentiell asymtotisch einem definierten Vollladezustand, d. h. der Nennkapazität, nähert. Die Nennkapazität ist für Speicherbatterien vom Hersteller bereits angegeben. Dabei hat sich überraschender Weise herausgestellt, dass die Zeitkonstante der Exponentialfunktion im wesentlichen von dem Speicherbatterietyp und der Batterie- oder Elektrolyttemperatur abhängt. Der Einfluss des Ladezustands zu Beginn der Ladungsaufnahme sowie der mittleren Ladespannung ist hingegen sehr viel geringer und muss nicht unbedingt berücksichtigt werden. Alle weiteren Einflüsse sind völlig vernachlässigbar.

Damit reduziert sich der Messaufwand zur Bestimmung der aufgenommenen Ladung auf eine Messung der Batterie- oder Elektrolyttemperatur, wobei die gemessene Batterie- oder Elektrolyttemperatur in eine für die Speicherbatterie festgelegte Funktion zur Berechnung der Zeitkonstanten eingesetzt wird. Diese Funktion kann beispielsweise experimentell für jede Speicherbatterie bestimmt werden.

Vorzugsweise wird die Zeitkonstante weiterhin noch in Abhängigkeit von dem Ladezustand zu Beginn der Ladungsaufnahme festgelegt. Besonders vorteilhaft ist es, wenn die Zeitkonstante weiterhin in Abhängigkeit von der Ladespannung, einer mittleren Ladespannung oder einer Nennladespannung festgelegt wird.

So kann die Zeitkonstante mit drei miteinander multiplizierten Faktoren bestimmt werden, wobei der erste Faktor mit einer vom Speicherbatterietyp und der Ladespannung bzw. der mittleren Ladespannung oder der Nennladespannung abhängigen Funktion, der zweite Faktor mit einer von dem Ladezustand zu Beginn der Ladungsaufnahme abhängigen Funktion und der dritte Faktor mit einer von der Batterie- oder Elektrolyttemperatur abhängigen Funktion berechnet wird.

Die absolute Ladungsaufnahme der Speicherbatterie kann beispielsweise als Funktion

$$\Delta Q \approx (1 - e^{-T/\tau})\,(Q_0 - Q_S)$$

 mit der Nennkapazität $Q_O$ der Speicherbatterie und der anfänglichen Ladung $Q_S$ der Speicherbatterie zu Beginn der Ladungsaufnahme berechnet werden.

Es kann aber auch eine auf die Nennkapazität $Q_O$ bezogener relativer Ladungszustand der Speicherbatterie als Funktion

$$Q(t) / Q_0 \approx 1 - (1 - Q_S / Q_0)\, e^{-T/\tau}$$

berechnet werden.

Der dritte Faktor als Funktion der Batterie- oder Elektrolyttemperatur kann beispielsweise ein erster Korrekturfaktor $\tau_T$ für die Zeitkonstante $\tau$ sein, der sich nach der Formel

$$\tau_T = a^{-(T_e - T_{e,0}) / b}$$

mit der Elektrolyttemperatur $T_e$ der Speicherbatterie, einer definierten Elektrolytnenntemperatur $T_{e,O}$ und den Konstanten a und b bestimmt wird. Mit diesem ersten Korrekturfaktor $\tau_T$ wird der Einfluss der Elektrolyttemperatur auf die Ladungsaufnahme der Speicherbatterie berücksichtigt. Diese Funktion beruht auf dem Arenius-Gesetz, da die begrenzenden physiko-chemische Reaktionen Lösungsreaktionen sind. Für eine auf Raumtemperatur von etwa 20°C genormte Zeitkonstante $\tau$ hat sich hierbei eine Konstante a mit dem Wert 2 mit einer Toleranz von $\pm$ 0,5 und eine Konstante b mit einem Wert von 10 und einem Toleranzbereich von $\pm$ 1 als geeignet herausgestellt.

Der Einfluss des Ladezustands zu Beginn der Ladungsaufnahme kann durch einen zweiten Korrekturfaktor $\tau_{Qs} / Q_O$ für die Zeitkonstante $\tau$ ausgedrückt werden, deren Wertebereich von 1 bis 1 - $Q_s / Q_O$ liegen sollte. Der Quotient $Q_s / Q_O$ ist die auf die Nennkapazität $Q_O$ bezogene anfängliche Ladung $Q_s$ zu Beginn der Ladungsaufnahme.

Die Aufgabe wird weiterhin durch einer Überwachungseinrichtung gelöst, die Rechenmittel zur Durchführung des vorherbeschriebenen Verfahrens aufweist. Die Rechenmittel können beispielsweise als Computerprogramm ausgeführt sein, das auf ein Prozessor, beispielsweise einem zentralen Fahrzeugrechner eines Kraftfahrzeugs, ausgeführt wird. Die Aufgabe wird weiterhin durch ein Computerprogramm mit Programmcodemitteln gelöst, die zur Durchführung des oben beschriebenen Verfahrens ausgebildet sind.

Die Erfindung wird nachfolgend anhand der beigefügten Zeichnungen näher erläutert. Es zeigen:

Fig.1 - Diagramm gemessener und nach dem erfindungsgemäßen Verfahren ermittelter relativer kumulierter Ladungsaufnahmen in Abhängigkeit von dem anfänglichen Ladezustand;

Fig. 2 - Diagramm gemessener und nach dem erfindungsgemäßen Verfahren ermittelter relativer kumulierter Ladungsaufnahmen in Abhängigkeit von dem anfänglichen Ladezustand, wobei die Zeitkonstante der Exponentialfunktion mit einem temperaturabhängigen Korrekturfaktor korrigiert ist;

Fig. 3 - Diagramm der relativen kumulativen Ladungsaufnahme für eine Elektrolytemperatur von 25°C in Abhängigkeit von dem anfänglichen Ladezustand und der Zeit bei konstanter Ladespannung einer BleiSäure-Kraftfahrzeugbatterie;

Fig. 4 - Diagramm der relativen kumulativen Ladungsaufnahme für eine Elektrolyttemperatur von -10°C als Funktion des anfänglichen Ladezustands und der Ladezeit bei konstanter Ladespannung einer BleiSäure-Kraftfahrzeugbatterie.

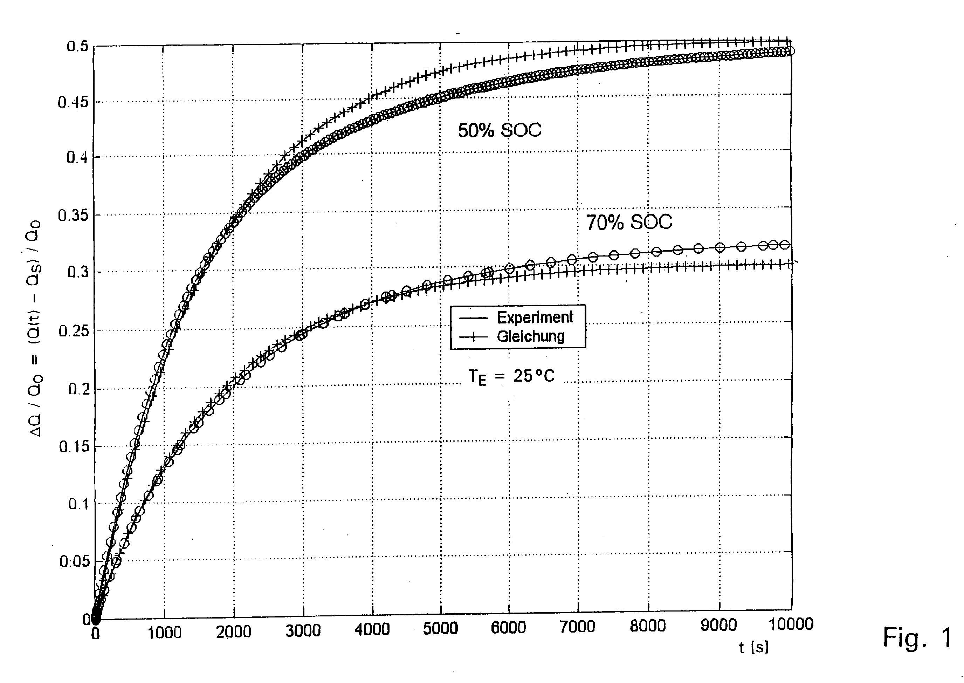

Die Figur 1 lässt ein Diagramm der relativen kumulierten Ladungsaufnahme $\Delta Q(t) / Q_0 = \dfrac{Q(t) - Q_s}{Q_0}$

für anfängliche Ladezustände $Q_s / Q_0$ von 50 % SOC und 70 % SOC (SOC = State of Charge) erkennen. Die Ladungsaufnahme ist in Abhängigkeit von der Zeit des Ladevorgangs aufgetragen und bei Batterie- bzw. Elektrolyttemperaturen von 25°C durchgeführt.

Dabei wurde die Ladungsaufnahme experimentell ermittelt und im Vergleich hierzu mit dem erfindungsgemäßen Verfahren berechnet. Die experimentell ermittelten Ladungsaufnahmen sind durch die mit Kreisen gekennzeichneten Kurven dargestellt. Die erfindungsgemäß ermittelten Ladungsaufnahmen sind durch die mit Querstrich gekennzeichneten Kurven dargestellt.

Es ist erkennbar, dass die erfindungsgemäß ermittelten und experimentell bestimmten Kurven der relativen kumulierten Ladungsaufnahme eine gute Übereinstimmung zueinander haben.

Zum Zeitpunkt t = 0 hat die Speicherbatterie eine anfängliche Ladung $Q_s$ und einen auf die Nennkapazität $Q_O$ bezogenen anfänglichen Ladezustand $Q_s / Q_O$. Der anfängliche Ladezustand $Q_s / Q_O$ beträgt für den ersten Fall a) 50 % SOC und für den zweiten Fall b) 70 % SOC. Die verbleibenden 50 % bzw. 30 % Ladung, die bis zum Erreichen des Voll-Ladezustands mit Nennkapazität $Q_O$ mindestens aufgenommen werden können, werden durch die Speicherbatterie über die Zeit in einem annähernd exponentiell verlaufenden Ladevorgang aufgenommen.

Die dargestellte relative Ladungsaufnahme $\Delta Q(t) / Q_O$ entspricht der auf die Nennkapazität $Q_O$ bezogene absolute Ladungsaufnahme während des Ladungsvorgangs.

Die relative Ladungsaufnahme wird erfindungsgemäß proportional zur Formel:

$$\Delta Q / Q_0 \approx (1 - e^{-T/\tau})(1 - Q_s / Q_0)$$

ermittelt, wobei t die Zeit und $\tau$ eine spezifische Zeitkonstante ist. Die Zeitkonstante ist erfindungsgemäß eine Funktion des Speicherbatterietyps, der Batterieoder Elektrolytemperatur $T_e$, des anfänglichen Ladezustands $Q_s / Q_O$ und der Ladespannung $U_L$. Als Ladespannung kann die Ladespannung $U_L(t)$ über die Zeit, eine mittlere Ladespannung $\overline{U}_L$ oder eine Ladenennspannung $U_{L,O}$ o. ä. eingesetzt werden.

Wesentlich ist, dass die Zeitkonstante $\tau$ eine Funktion der Batterie- oder Elektrolyttemperatur und des Speicherbatterietyps ist. Die Abhängigkeit der optimalen Zeitkonstanten $\tau$ bzw. der Exponentialfunktion ist hingegen nur relativ gering von dem anfänglichen Ladezustand $O_s / Q_O$ zu Beginn der Ladungsaufnahme sowie von der Ladespannung $u_L$ abhängig. Die Ladespannung $U_L$ kann bereits als Speicherbatterietyp-spezifischer Wert einfließen, wenn eine Funktion zur Bestimmung der Zeitkonstanten $\tau$ in Abhängigkeit von dem Speicherbatterietyp experimentell ermittelt wird.

Auch die berücksichtige Batterie- bzw. Elektrolyttemperatur kann beispielsweise als zu Beginn des Ladevorgangs gemessener Momentanwert bestimmt und für den nachfolgenden Ladevorgang konstant gehalten werden. Damit kann die Zeitkonstante $\tau$ für einen Ladevorgang einen konstanten Wert haben. Alternativ kann die Zeitkonstante $\tau$ aber auch als Funktion der Zeit während des Ladevorgangs angepasst werden.

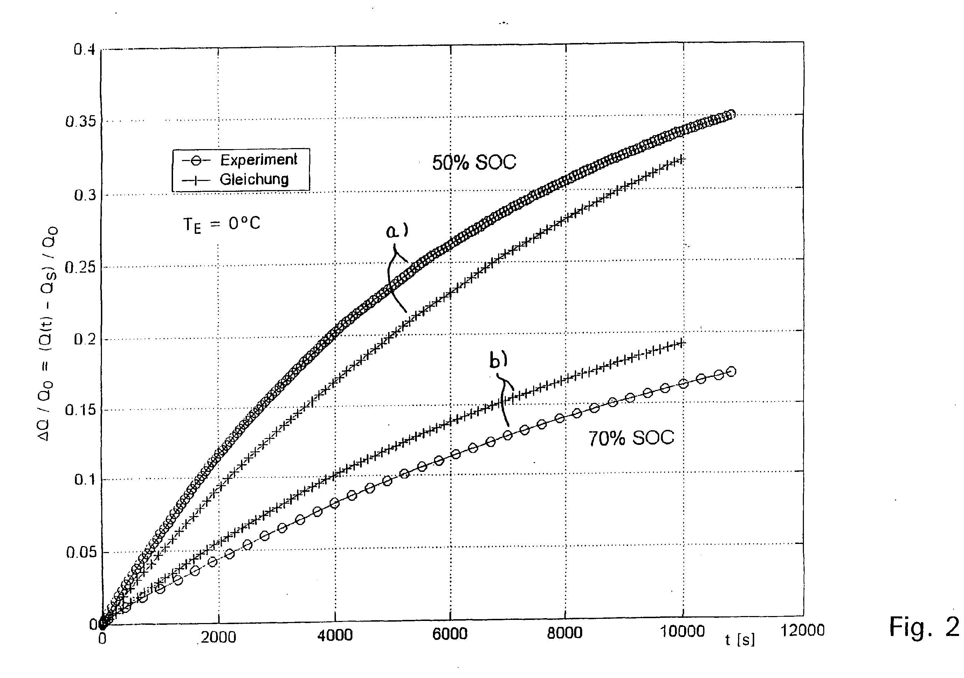

Die Figur 2 lässt ein Diagramm der relativen Ladungsaufnahme $\Delta Q(t) / Q_O = Q(t) - Q_s / Q_O$ bei einer Elektrolyttemperatur von 0°C und anfänglichen Ladezuständen $Q_s / Q_O$ von 50 % SOC und 70 % SOC erkennen. Wiederum wurden die Werte für die relative Ladungsaufnahme experimentell bestimmt und im Vergleich hierzu nach dem erfindungsgemäßen Verfahren rechnerisch ermittelt. In dem dargestellten Beispiel wurde die Zeitkonstante $\tau$ durch einen ersten Korrektufaktor $\tau_T$ korrigiert, der die Abhängigkeit der Zeitkonstanten $\tau$ von der Elektrolyttemperatur widerspiegelt. Da die begrenzenden physikalisch - chemischen Reaktionen Lösungsreaktionen sind, wurde auf Grundlage des Arenius-Gesetzes eine Korrekturgröße

$$\tau_T = a^{-(T_e - T_{e,0}) / b}$$

definiert und damit der Einfluss der Elektrolyttemperatur auf die Ladungsaufnahme der Speicherbatterie berücksichtigt. Hierbei ist $T_e$ die Elektrolyttemperatur und $T_{e,O}$ eine Elektrolytnenntemperatur. Die Konstanten a und b sind Größen, die experimentell bestimmt werden. Die Konstante a sollte einen Wert von etwa 2 mit einem Toleranzbereich von $\pm$ 0,5 und die Konstante b einen Wert von etwa 10 mit einem Toleranzbereich von $\pm$ 1 haben.

Aus der Figur 2 ist zu erkennen, dass mit einer derart korrigierten Zeitkonstanten $\tau$ eine relativ gute Übereinstimmung der berechneten relativen kumulierten Ladungsaufnahmen zu den gemessenen relativen kumulierten Ladungsaufnahmen besteht. Durch Optimierung der Konstanten a und b kann das Ergebnis der Ermittlung der Ladungsaufnahme in Abhängigkeit von dem Speicherbatterietyp noch weiter optimiert werden.

Die Abhängigkeit der Zeitkonstanten $\tau$ von dem relativen Ladezustand $Q_s / Q_O$ zu Beginn der Ladungsaufnahme ist sehr gering, da der während der Ladung sinkende Innenwiderstand $R_i$ der Speicherbatterie gemäß dem Produkt $\tau = R_i \times C$ von der steigenden Kapazität C der Speicherbatterie kompensiert wird. Bei der Berechnung einer Zeitkonstanten wird der anfängliche relative Ladungszustand $Q_s / Q_O$ vorzugsweise durch einen zweiten Korrekturfaktor

$$\tau_{Qs} / Q_0 = f(Q_s / Q_0)$$

bestimmt, wobei der zweite Korrekturfaktor $\tau_{Qs} / Q_O$ einen Wert zwischen 1 und $(1 - Q_s / Q_O)$ annehmen sollte.

Damit kann die Zeitkonstante $\tau$ nach der Beziehung:

$$f(Te)$$

bestimmt werden, wobei $\tau_{RTO}$ eine Zeitkonstante bei Raumtemperatur ist, die lediglich von dem Speicherbatterietyp und'der Ladespannung $U_L$ abhängig ist. Dieser Anteil $\tau_{RTO}$ einer Zeitkonstanten $\tau$ kann experimentell für Speicherbatterien eines Typs und Fahrzeugen eines Herstellers bezüglich der üblichen Ladespannung $U_L$ experimentell ermittelt werden, so dass zur Ermittlung der Ladungsaufnahme lediglich eine Temperaturmessung erforderlich ist.

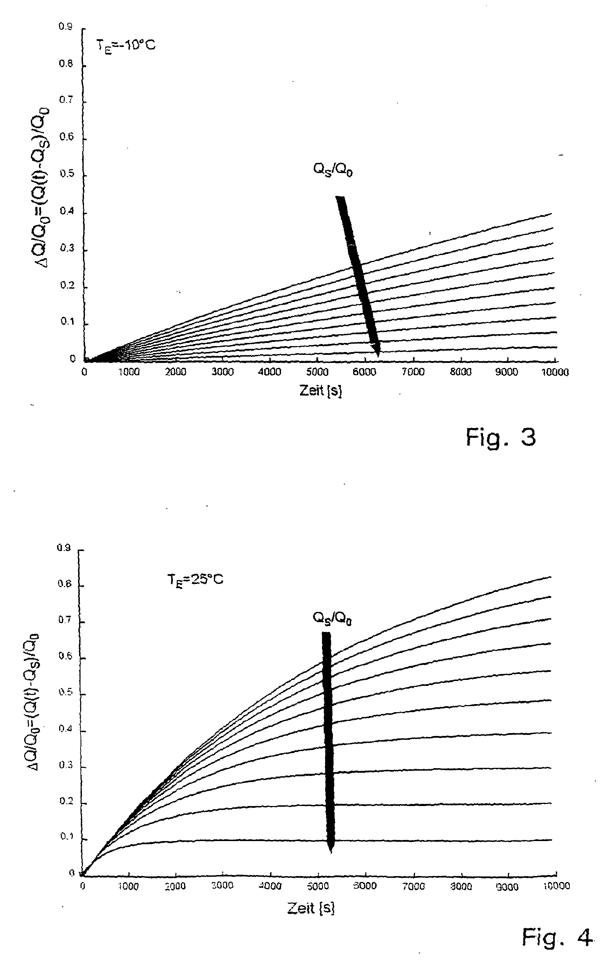

Die Figur 3, zeigt ein Diagramm der relativen kumulativen Ladungsaufnahme $\Delta Q(t) / Q_O$ in Abhängigkeit von dem anfänglichen relativen Ladezustand $Q_s / Q_O$ zu Beginn der Ladungsaufnahme und der Ladezeit t bei einer konstanten Ladespannung von 14,2 V und eine Elektrolyttemperatur von 10°C am Beispiel einer Blei-Säure-Kraftfahrzeugbatterie. Es wird deutlich, dass die Ladungsaufnahme einen Exponentialverlauf aufweist. Im weiten Bereich eines anfänglichen relativen Ladezustands $Q_s / Q_O$ von etwa 0 % bis 0,7 % ist eine große Linearität der für verschiedene anfängliche Ladezustände angrenzende Exponentialkurven zu erkennen. Die bedeutet, dass der Einfluss des anfänglichen relativen Ladezustands auf den Kurvenverlauf gering ist.

Die Figur 4 lässt die relative kumulative Ladungsaufnahme $\Delta Q(t) / Q_O$ in Abhängigkeit von dem anfänglichen relativen Ladezustand $O_s / Q_O$ zu Beginn der Ladungsaufnahme und der Zeit t bei einer konstanten Ladespannung von 14,2 V und einer Elektrolyttemperatur von 25°C erkennen. Es wird im Vergleich zu dem Kurvenverlauf der Figur 3 deutlich, dass der Verlauf der Ladungsaufnahme bei veränderten Elektrolyttemperaturen $T_e$ stark geändert ist. Der Kurvenverlauf folgt jedoch wiederum einer Exponentialfunktion.

## Patentansprüche

1. Verfahren zur Ermittlung der Ladungsaufnahme ($\Delta Q(t)$) einer Speicherbatterie ausgehend von einem anfänglichen Ladezustand ($O_S/Q_0$) zu Beginn der Ladungsaufnahme, **dadurch gekennzeichnet, dass** die Ladungsaufnahme in Abhängigkeit von einer Exponentialfunktion mit einer Zeitkonstanten ($\tau$) bestimmt wird, wobei die Zeitkonstante ($\tau$) mindestens in Abhängigkeit von dem Speicherbatterietyp und der Batterie- oder Elektrolyttemperatur ($T_e$) festgelegt wird, **gekennzeichnet dadurch daß** der Speicherbatterietyp über einen vom Speicherbatterietyp und der Ladespannung ($U_L$) abhängigen Anteil der Zeitkonstanten ($T_{RTO}$) berücksichtigt wird.

2. Verfahren nach Anspruch 1, **dadurch gekennzeichnet, dass** die Zeitkonstante ($\tau$) weiterhin in Abhängigkeit von dem Ladezustand ($Q_S/Q_0$) zu Beginn der Ladungsaufnahme festgelegt wird.

3. Verfahren nach Anspruch 1 oder 2, **dadurch gekennzeichnet, dass** die Zeitkonstante ($\tau$) weiterhin in Abhängigkeit von der Ladespannung ($U_L(t)$), einer mittleren Ladespannung ($\overline{U}_L$) oder einer Nennladespannung ($U_{L,0}$) festgelegt wird.

4. Verfahren nach einem der vorhergehenden Ansprüche, **gekennzeichnet durch** Ermitteln der absoluten Ladungsaufnahme ($\Delta Q$) als Funktion

$$\Delta Q \approx (1 - e^{-t/\tau})\,(Q_0 - Q_s),$$

mit $Q_0$ als definierte Nennkapazität der Speicherbatterie und $Q_s$ als anfängliche Ladung der Speicherbatterie zu Beginn der Ladungsaufnahme.

5. Verfahren nach einem der vorgehenden Ansprüche, **gekennzeichnet durch** Ermitteln des auf die Nennkapazität ($Q_0$) bezogenen relativen Ladungszustands ($Q(t)/Q_0$) der Speicherbatterie als Funktion:

$$Q\,(t)/Q_0 \approx 1 - (1 - Q_s/Q_0)\,e^{-t/\tau}.$$

6. Verfahren nach einem der vorhergehenden Ansprüche, **gekennzeichnet durch** einen ersten Korrekturfaktor ($\tau_T$) für die Zeitkonstante ($\tau$), wobei der ersten Korrekturfaktor ($\tau_T$) nach der Formel:

$$\tau_T = a^{-(T_e - T_{e,0}) / b}$$

mit der Elektrolyttemperatur $T_e$ der Speicherbatterie, einer definierten Elektrolynenntemperatur $T_{e,0}$ und den Konstanten a und b bestimmt wird.

**7.** Verfahren nach Anspruch 6, **dadurch gekennzeichnet, dass** die Konstante a im Wertebereich von 1,5 bis 2,5 und die Konstante b im Wertebereich von 9 bis 11 festgelegt ist.

**8.** Verfahren nach einem der vorhergehenden Ansprüche, **gekennzeichnet durch** einen zweiten Korrekturfaktor ($\tau_{Qs}$ / $Q_0$) für die Zeitkonstante ($\tau$), wobei der zweite Korrekturfaktor ($\tau_{Qs}$ / $Q_0$) im Wertebereich von 1 bis 1 - $Q_s$ / $Q_0$ festgelegt ist.

**9.** Überwachungseinrichtung für Speicherbatterien mit einer Batterietemperaturmesseinheit und mit Rechenmitteln zur Ermittlung der Ladungsaufnahme der Speicherbatterie ausgehend von einem anfänglichen Ladezustand ($Q_s$ / $Q_0$) zu Beginn der Ladungsaufnahme, **dadurch gekennzeichnet, dass** die Rechenmittel zur Durchführung des Verfahrens nach einem der vorhergehenden Ansprüche ausgebildet sind.

**10.** Computerprogramm mit Programmcodemitteln, **dadurch gekennzeichnet, dass** die Programmcodemittel zur Durchführung des Verfahrens nach einem der Ansprüche 1 bis 8 ausgebildet sind, wenn das Computerprogramm mit einer Prozessoreinrichtung ausgeführt wird.

**11.** Computerprogramm nach Anspruch 10, **dadurch gekennzeichnet, dass** das Computerprogramm als eine auf einem Datenträger gespeicherte Programmdatei verkörpert ist.

## Claims

**1.** Method for determination of the charge drawn ($\Delta Q(t)$) by an energy storage battery starting from an initial state of charge ($Q_s/Q_0$) at the start of the drawing of the charge, **characterized in that** the charge drawn is determined as a function of an exponential function with a time constant ($\tau$), with the time constant ($\tau$) being defined at least as a function of the energy storage battery type and of the battery or electrolyte temperature ($T_e$), **characterized in that** the energy storage battery type is considered by use of a ratio of the time constant ($\tau_{RTO}$) which is dependent on the energy storage battery type and on the charging voltage ($U_L$).

**2.** Method according to Claim 1, **characterized in that** the time constant ($\tau$) is also defined as a function of the state of charge ($Q_s/Q_0$) at the start of the drawing of the charge.

**3.** Method according to Claim 1 or 2, **characterized in that** the time constant ($\tau$) is also defined as a function of the charging voltage ($U_L(t)$), of a mean charging voltage ($\overline{U}_L$) or of a rated charging voltage ($U_{L,0}$).

**4.** Method according to one of the preceding claims, **characterized by** determination of the absolute amount of charge drawn ($\Delta Q$) as a function

$$\Delta Q \approx (1 - e^{-t/\tau}) (Q_0 - Q_s),$$

where $Q_0$ is the defined rated capacity of the energy storage battery and as is the initial charge of the energy storage battery at the start of the drawing of the charge.

**5.** Method according to one of the preceding claims, **characterized by** determination of the relative state of charge ($Q(t)/Q_0$), with respect to the rated capacity ($Q_0$), of the energy storage battery as a function:

$$Q(t)/Q_0 \approx 1 - (1 - Q_s/Q_0)\, e^{-t/\tau}.$$

**6.** Method according to one of the preceding claims, **characterized by** a first correction factor ($\tau_T$) for the time constant ($\tau$), with the first correction factor ($\tau_T$) being determined using the formula:

$$\tau_T \ = \ a^{-(T_e - T_{e,0})\,/\,b}$$

where $T_e$ is the electrolyte temperature of the energy storage battery, $T_{e,0}$ is a defined electrolyte nominal temperature and a and b are the constants.

**7.** The method as claimed in Claim 6, **characterized in that** the constant a is defined in the value range from 1.5 to 2.5, and the constant b is defined in the value range from 9 to 11.

**8.** Method according to one of the preceding claims, **characterized by** a second correction factor ($\tau_{Qs}/Q_0$) for the time constant ($\tau$), with the second correction factor ($\tau Q_s/Q_0$) being defined in the value range from 1 to $1 - Q_s/Q_0$.

**9.** Monitoring device for energy storage batteries having a battery temperature measurement unit and having computation means for determination of the charge drawn by the energy storage battery starting from an initial state of charge ($Q_s/Q_0$) at the start of the drawing of the charge, **characterized in that** the computation means are designed to carry out the method according to one of the preceding claims.

**10.** Computer program having program code means, **characterized in that** the program code means are designed to carry out the method according to one of Claims 1 to 8, when the computer program is run using a processor device.

**11.** Computer program according to Claim 10, **characterized in that** the computer program is embodied as a program file which is stored on a data storage medium.


**Revendications**

**1.** Procédé pour déterminer la prise de charge ($\Delta Q(t)$) d'une batterie d'accumulateurs à partir d'un état de charge initial ($Q_S/Q_0$) au début de la prise de charge,
**caractérisé en ce que**
la prise de décharge est déterminée en fonction d'une fonction exponentielle avec une constante de temps ($\tau$), la constante de temps $\tau$ étant fixée au moins en fonction du type de batterie d'accumulateurs et de la température de la batterie ou de l'électrolyte ($T_e$),
**caractérisé en ce que**
le type de batterie d'accumulateurs est pris en compte par l'intermédiaire d'une fraction de la constante de temps ($T_{RTO}$) dépendant du type de batterie d'accumulateurs et de la tension de charge ($U_L$).

**2.** Procédé selon la revendication 1,
**caractérisé en ce que**
la constante de temps ($\tau$) est fixée en outre en fonction de l'état de charge ($Q_s/Q_0$) au début de la prise de charge.

**3.** Procédé selon la revendication 1 ou la revendication 2,
**caractérisé en ce que**
la constante de temps ($\tau$) est fixée en outre en fonction de la tension de charge ($U_L(t)$), d'une tension de charge moyenne ($U_L$) ou d'une tension de charge nominale ($U_{L,0}$).

**4.** Procédé selon l'une quelconque des revendications précédentes,
**caractérisé par**
la détermination de la prise de charge absolue ($\Delta Q$) en tant que fonction

$$\Delta Q \approx (1 - e^{-t/\tau}) (Q_0 - Q_S),$$

dans laquelle $Q_0$ est la capacité nominale définie de la batterie d'accumulateurs et $Q_S$ est la charge initiale de la batterie d'accumulateurs au début de la prise de charge.

5. Procédé selon l'une quelconque des revendications précédentes,
   **caractérisé par**
   l'état de charge relatif ($Q(t)/Q_0$) de la batterie d'accumulateurs par rapport à la capacité nominale ($Q_0$) en tant que fonction

$$Q(t)/Q_0 \approx 1 - (1 - Q_S/Q_0) e^{-t/\tau}.$$

6. Procédé selon l'une quelconque des revendications précédentes,
   **caractérisé par**
   un premier facteur de correction ($\tau_T$) pour la constante de temps ($\tau$), le premier facteur de correction ($\tau_T$) selon la formule :

$$\tau_T = a^{-(T_e - T_{e,0})/b}$$

étant déterminé avec la température de l'électrolyte $T_e$ de la batterie d'accumulateurs, une température nominale de l'électrolyte définie $T_{e,0}$ et les constantes a et b.

7. Procédé selon la revendication 6,
   **caractérisé en ce que**
   la constante a a une valeur de l'ordre de 1,5 à 2,5 et la constante b une valeur de l'ordre de 9 à 11.

8. Procédé selon l'une quelconque des revendications précédentes,
   **caractérisé par**
   un deuxième facteur de correction ($\tau_{Qs}/Q_0$) pour la constante de temps ($\tau$), la valeur du deuxième facteur de correction ($\tau_{Qs}/Q_0$) étant de l'ordre de 1 à 1 - $Q_s/Q_0$.

9. Dispositif de surveillance pour batteries d'accumulateurs comportant une unité de mesure de la température de la batterie et des moyens de calcul pour déterminer la prise de charge de la batterie d'accumulateurs à partir d'un état de charge initial ($Q_s/Q_0$) au début de la prise de charge,
   **caractérisé en ce que**
   les moyens de calcul sont configurés pour la réalisation du procédé selon l'une quelconque des revendications précédentes.

10. Programme informatique comportant des moyens de codage informatiques,
    **caractérisés en ce que**
    les moyens de codage informatiques sont configurés pour réaliser le procédé selon l'une quelconque des revendications 1 à 8 lorsque le programme informatique est exécuté par un processeur.

11. Programme informatique selon la revendication 10,
    **caractérisé en ce que**
    le programme informatique est un fichier programme enregistré sur un support de données.

Fig. 1

EP 1 420 261 B1

Fig. 2

Fig. 3

Fig. 4

**EP 1 420 261 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5936383 A